# EUROPEAN PATENT SPECIFICATION

(11) **EP 2 364 510 B1**
(45) Date of publication and mention of the grant of the patent: **12.02.2014**
(21) Application number: 09749288.8
(22) Date of filing: 04.11.2009
(51) Int. Cl.: C22C 1/04, C22C 13/00, C22C 19/00, C22C 28/00, H01L 35/22

(54) **CLATHRATE COMPOUNDS AND THEIR PREPARATION AND USE**
CLATHRATVERBINDUNGEN UND IHRE HERSTELLUNG UND VERWENDUNG
COMPOSÉS CLATHRATES, LEURS PRÉPARATION ET UTILISATION

(30) Priority: 07.11.2008 CN 200810202414
(43) Date of publication of application: 14.09.2011
(73) Proprietor: Corning Incorporated, Corning, NY 14831 (US); Shanghai Institute Of Ceramics, Chinese Academy Of Sciences, Shanghai 200050 (CN)
(72) Inventor: BAI, Shengqiang, Shanghai 200436 (CN); CHEN, Lidong, Shanghai 200336 (CN); HE, Lin, Corning New York 14830 (US); WANG, Li, Shanghai 200050 (CN); ZHANG, Wenbin, Shanghai 201210 (CN)
(74) Representative: Oldroyd, Richard Duncan
(86) International application number: PCT/US2009/063273
(87) International publication number: WO 2010/053988

(56) References cited:
- WO-A1-2006/095839
- WO-A2-2005/073131
- JP-A- 2005 136 032
- JP-A- 2006 339 283
- JP-A- 2008 034 721
- JP-A- 2008 047 806
- US-A1- 2002 088 485
- ANNO H ET AL: "Thermoelectric properties of Ba8GaxGe46-x clathrate compounds" THERMOELECTRICS, 2002. PROCEEDINGS ICT '02. TWENTY-FIRST INTERNATIONAL CONFERENCE ON AUG. 25-29, 2002, PISCATAWAY, NJ, USA,IEEE, 25 August 2002 (2002-08-25), pages 77-80, XP010637435 ISBN: 978-0-7803-7683-0
- TANG XINFENG ET AL: "High temperature thermoelectric transport properties of double-atom-filled clathrate compounds YbxBa8â xGa16Ge30" JOURNAL OF APPLIED PHYSICS, AMERICAN INSTITUTE OF PHYSICS. NEW YORK, US LNKD- DOI:10.1063/1.2951888, vol. 104, no. 1, 8 July 2008 (2008-07-08), pages 13706-13706, XP012116322 ISSN: 0021-8979
- MARTIN J ET AL: "Thermoelectric properties of silicon-germanium type I clathrates" JOURNAL OF APPLIED PHYSICS, AMERICAN INSTITUTE OF PHYSICS. NEW YORK, US LNKD- DOI:10.1063/1.2817400, vol. 102, no. 10, 29 November 2007 (2007-11-29), pages 103719-103719, XP012101145 ISSN: 0021-8979
- ZHANG YUEGANG ET AL: "Gallium distribution in the clathrates Sr8Ga16Ge30 and Sr4Eu4Ga16Ge30 by resonant diffraction" APPLIED PHYSICS LETTERS, AIP, AMERICAN INSTITUTE OF PHYSICS, MELVILLE, NY, US LNKD- DOI:10.1063/1.1473236, vol. 80, no. 16, 22 April 2002 (2002-04-22), pages 2931-2933, XP012030642 ISSN: 0003-6951
- SRINATH S ET AL: "Giant magnetocaloric effect in clathrates" JOURNAL OF APPLIED PHYSICS, AMERICAN INSTITUTE OF PHYSICS. NEW YORK, US, vol. 99, no. 8, 18 April 2006 (2006-04-18) , pages 8K902-08K902, XP012084641 ISSN: 0021-8979

## Description

### FIELD OF THE DISCLOSURE

Embodiments of the present invention relate to clathrate compounds, their preparation, and their use. These clathrate compounds may be used, for example, as thermoelectric materials.

### BACKGROUND

A thermoelectric material is a material that can convert thermal energy directly into electric energy. The performance of a thermoelectric material is characterized by the dimensionless figure of merit ZT (ZT=TS²σ/κ), wherein S is the Seebeck coefficient, σ is the electrical conductivity, κ is the thermal conductivity, and T is the absolute temperature. From the expression of ZT, it can be seen that a thermoelectric material with good thermoelectric performance should possess a low thermal conductivity, a high electrical conductivity, and a high Seebeck coefficient.

Generally, narrow band semiconductor materials with low thermal conductivity may be appropriate candidates for thermoelectric materials. Certain clathrate compounds can also serve as thermoelectric materials. The definition of a clathrate compound is well known to those skilled in the art, and is discussed in the literature such as in "Thermoelectrics: Basic Principles and New Materials Developments, G. S. Nolas, Springer, 2001"; US Patent No. US6188011B1; Japanese Patent Publication No. 2002-274831A; Chinese Patent Publication No. CN101116193A or its patent family member WO2006/095839 and the like.

A type-I clathrate structure compound has 46 framework sites, mainly occupied by IV-A group atoms (B) which can be partly substituted by III-A group atoms (A). There are 8 cavities or cages in the crystal lattice, which can be filled by alkali metal, alkali earth metal or rare earth atoms or Cd atoms (M). See Thermoelectrics: Basic Principles and New Materials Developments, G. S. Nolas, Springer, 2001. The lattice thermal conductivity of type-I clathrate materials can be reduced dramatically due to the increased "phonon scattering" caused by the filling atoms in the cavities. Meanwhile, the carriers are transported by the crystal lattice atoms, and influenced weakly by the turbulence of filling atoms. Therefore, these kinds of materials have low thermal conductivity and excellent electric transport properties. For those materials of low thermal conductivity, the thermoelectric properties can be further improved by optimizing the electric transport properties, for example by adjusting the atoms in the crystal lattice structure.

Compounds of the formula M₈AₓB₄₆₋ₓ, Ba₈GaₓGe₄₄₋ₓ and Ba₈Ge₄₃ having different types of filling atoms and crystal lattice atoms and atom vacancy have been proposed, for example, in US Patent No. US6188011B1; Japanese Patent Publication No. 2002-274831A; and Chinese Patent Publication No. CN101116193A. In the above materials, the number of the crystal lattice atoms greatly influences the properties of the clathrate thermoelectric materials. Little is known, however, concerning how to enhance thermoelectric properties through increasing the vacant sites in the ternary clathrate structure.

Since main raw materials for the clathrates are easily oxidized and the vapor pressure of some raw materials is high at high temperature, process control in making clathrates is very difficult and the purity of the synthesized clathrate compounds is also often low. Preparation of the compounds often requires a special protective atmosphere, complicated equipment and processes, and high energy consumption to make high purity materials. Impurities such as Ge, which are formed during the synthetic process, will deteriorate electrical properties of the thermoelectric materials and can diminish the ultimate thermoelectric properties. For instance, J. Daniel Bryan et al. synthesized Ba8Ga16Ge30 materials by a zone refinement method, but impurity phase Ge was found in their final samples (J. Appl. Phys. 92, 127281, 2002). Isao Fujita et al. synthesized Sr8GaxGe46-x materials by an arc melting method. The presence of Ge impurity phase deteriorates electrical property markedly and increases lattice thermal conductivity (J. Appl. Phys. 99, 033513, 2006). The Ge impurity phase is very stable and can not be removed by heat treatment or acid-washing. Therefore, in order to obtain a clathrate compound with excellent thermoelectric performance, it is advisable to reduce to a minimum the amount of impurities in the material. In addition, and up to the present, the ability to control purity and to obtain desired compositions is still limited and an ideal optimization of thermoelectric properties has not yet been found.

In view of the above, there continues to be a need for clathrate compounds with desirable thermoelectric performance and processes for making them.

### SUMMARY

One embodiment of the invention includes a clathrate compound having the following formula (I):

M₈AₓB_{y-x} (I)

wherein:
M is an alkaline earth metal, a rare earth metal, an alkali metal, Cd, or a combination thereof,
A is Ga, Al, In, Zn or a combination thereof;
B is Ge, Si, Sn, Ni or a combination thereof; and
12≤x≤16, 40≤y≤43.

Another embodiment includes a process for making the clathrate compound of formula (I), which comprises:
(a) providing a mixture of the components A, B and M, at least one of which is provided in stoichiometric excess;
(b) melting and quenching the mixture from step (a) to obtain a quenched mixture;
(c) crushing the quenched mixture from step (b) to a powder;
(d) washing the powder from step (c) with an acid to obtain a washed powder of the quenched mixture; and
(e) sintering the washed powder of the quenched mixture from step (d) to obtain the clathrate compound.

Further embodiments of the invention include thermoelectric materials comprising the clathrate compound and use of the clathrate compound as a thermoelectric material.

### BRIEF DESCRIPTION OF THE DRAWINGS

Figure 1 is a scanning electron microscope image (SEM) of the polished surface of Ba₈Ga₁₂Ge₂₉ in Example 1, indicating that the obtained material is a pure phase of a clathrate compound.
Figure 2 is an energy spectrum analysis for the elemental composition of area 1 shown in Figure 1, indicating that the elemental composition of the material is Ba, Ga, and Ge.
Figure 3 shows the temperature dependence of the ZT value of Ba₈Ga₁₂Ge₂₉ in Example 1, indicating that the material has favorable thermoelectric properties.
Figure 4 shows the temperature dependence of the ZT value of Ba₈Ga₁₅Ge₃₁ in Comparative Example 1.
Figure 5 is an X-ray diffraction pattern of Sr₈Ga₁₃Ge₂₇ in Example 2, indicating that the obtained material has a type I clathrate structure phase.
Figure 6 shows the temperature dependence of the ZT value of Sr₈Ga₁₃Ge₂₇ in Example 2, indicating that the material has favorable thermoelectric properties.

### DETAILED DESCRIPTION

It is to be understood that both the foregoing general description and the following detailed description are exemplary and explanatory only, and are not restrictive of the invention, as claimed. Other embodiments of the invention will be apparent to those skilled in the art from consideration of the specification and practice of the invention disclosed herein. It is intended that the specification be considered as exemplary only, with the true scope of the invention being indicated by the claims.

The clathrate compounds described herein can have favorable thermoelectric properties and can be particularly suitable as thermoelectric materials. The following contents describe various aspects of the present invention in further detail.

### Clathrate compounds

One embodiment of the invention includes a clathrate compound having the following formula (I):

M₈AₓB_{y-x} (I)

wherein:
M is an alkaline earth metal, a rare earth metal, an alkali metal, Cd, or a combination thereof;
A is Ga, Al, In, Zn or a combination thereof;
B is Ge, Si, Sn, Ni or a combination thereof; and
12≤x≤16, 40≤y≤43.

In some embodiments, the clathrate compound of formula (I) meets one or a combination of several of the following conditions:
(i) M is an alkaline earth metal, such as Sr, Ba, or a combination thereof;
(ii) M is a rare earth metal, such as Eu, Yb, or a combination thereof;
(iii) M is an alkali metal, such as K, Na, or a combination thereof;
(iv) M is Cd;
(v) A is Ga, Al, In, or a combination thereof;
(vi) A is Al, In or Zn, or a combination thereof;
(vii) A is a mixture of Ga and Al in any ratio;
(viii) A is a mixture of Ga and In in any ratio;
(ix) A is a mixture of Ga and Zn in any ratio;
(x) B is Ge;
(xi) B is Si, Sn or a combination thereof;
(xii) B is Si, Sn, Ni, or a combination thereof;
(xiii) B is a mixture of Ge and Si in any ratio;
(xiv) B is a mixture of Ge and Sn in any ratio; and
(xv) B is a mixture of Ge and Ni in any ratio.

In further exemplary embodiments, M is Sr, Ba, or Eu; or a combination of Sr and Ba in any ratio, a combination of Sr and Eu in any ratio, a combination of Ba and Eu in any ratio, or M is a combination of Sr and Yb, and the molar ratio of Sr to Yb is no less than 7:1; or M is a combination of Eu and Yb, and the molar ratio of Eu to Yb is no less than 7:1. In another embodiment, M is Sr, Ba or the combination thereof.

In these and any other embodiments, x is, for example, within the range of 13≤x≤15, y is, for example, within the range of 40≤y≤42, for instance 41≤y≤42.

Examples of the clathrate compounds include, but are not limited to, the examples as shown in Table 1. In these embodiments, the range of x is 12≤x≤16, for instance 13≤x≤15; the range of y is 40≤y≤43, for instance 40≤y≤42, such as 41≤y≤42. M in the clathrate compounds (6) to (11) in Table 1 is Sr, Ba, Eu or the combination thereof. All ratios in Table 1 are ratios by mole.

**TABLE 1: EXEMPLARY CLATHRATE COMPOUNDS**

| | | |
|---|---|---|
| (1) | (Sr,Ba)₈A_{X}B_{y-X} | M is Sr, Ba or a mixture thereof in any ratio; A is Ga, Al or In, B is Ge, Si or Sn |
| (2) | (Sr,Eu)₈AₓB_{y-x} | M is Sr, Eu or a mixture thereof in any ratio; A is Ga, or Al, or In, B is Ge, or Si, or Sn |
| (3) | (Ba,Eu)₈AₓB_{y-x} | M is Ba, Eu or a mixture thereof in any ratio; A is Ga, or Al, or In ,B is Ge, or Si, or Sn |
| (4) | (Sr,Yb)₈AₓB_{y-x} | M is Sr, Yb, or a mixture thereof, and the ratio of Sr to Yb in the mixture is no less than 7: 1; A is Ga, or Al, or In ,B is Ge, or Si, or Sn |
| (5) | (Eu,Yb)₈AₓB_{y-x} | M is Eu, Yb, or a mixture thereof, and the ratio of Eu to Yb in the mixture is no less than 7: 1; A is Ga, or Al, or In ,B is Ge, or Si, or Sn |
| (6) | M₈(Ga,Al)_{X}B_{y-X} | The ratio of Ga to Al is arbitrary; B is Ge, or Si, or Sn |
| (7) | M₈(Ga,In)_{X}B_{y-X} | The ratio of Ga to In is arbitrary; B is Ge, or Si, or Sn |
| (8) | M₈(Ga,Zn)ₓB_{y-x} | The ratio of Ga to Al is no less than 15:1; B is Ge, or Si, or Sn |
| (9) | M₈Aₓ(Ge,Si)_{y-x} | The ratio of Ge to Si is arbitrary; A is Ga, or Al, or In |
| (10) | M₈Aₓ(Ge,Sn)_{y-x} | The ratio of Ge to Sn is arbitrary; A is Ga, or Al, or In |
| (11) | M₈Aₓ(Si,Sn)_{y-x} | The ratio of Si to Sn is arbitrary; A is Ga, or Al, or In |

Further examples of clathrate compounds are shown in the following Table 2:

**TABLE 2: ADDITIONAL EXEMPLARY CLATHRATE COMPOUNDS**

| | |
|---|---|
| Ba₈Ga₁₂Ge₂₉ | M is Ba, A is Ga, B is Ge, x=12, y=41 |
| Sr₈Ga₁₃Ge₂₇ | M is Sr, A is Ga, B is Ge, x=13, y=40 |
| Eu₈Ga₁₆Ge₂₆ | M is Eu, A is Ga, B is Ge, x=16, y=42 |

The clathrate compounds of the present invention may further contain impurities that may be unavoidable, such as oxides of Ga, Ge, Sr, Ba or the combination of these oxides. Such impurities may be present in trace amounts that do not significantly detract from the favorable properties of the clathrate compounds.

Without being bound by any particular theory, it is hypothesized that the vacancy of the crystal lattice atoms in the clathrate compound of the present invention dramatically increases the Seebeck coefficient of the material, and that such an increase is more than sufficient to compensate for any loss of electric conductivity. With ZT being proportional to the square of Seebeck coefficient, the materials are expected to possess favorable thermoelectric properties.

### Exemplary preparation methods

The clathrate compounds of the present invention can be synthesized using the techniques discussed below and any other appropriate techniques, for example, using commercially available starting materials and appropriate chemical syntheses.

Embodiments of the invention include the use of an excess stoichiometric ratio of certain starting materials M, A or B to obtain a clathrate compound described above.

Without being bound to any particular theory, it is hypothesized that, in preparation methods of other art, the starting material M has a high vapor pressure and is evaporated easily during the synthesis process, resulting in Ge in the second phase not being removed by post-treatment. In embodiments of the present invention, a specific amount of M is provided in stoichiometric excess and can form a binary compound impurity phase with the starting materials A and B. Removal of the impurity phase should not affect the purity of the target product. Meanwhile, the starting materials A and B will be consumed and the final material has the formula (I) indicated above. Such a process endows the material of the present invention with high purity, vacancy of the crystal lattice atoms, and excellent thermoelectric properties. In this respect, the figure-of-Merit (ZT) value can reach as high as 1.35 at 900K.

In one embodiment of the stoichiometric ratio excess, the base number of M is 8, and the amount of M component used is more than 15 mole% stoichiometric ratio excess based on the base number. An upper stoichiometric ratio excess may be, for example, no more than 100% by mole; and may also be no less than 20% by mole.

In another embodiment, the base number of A is x, and the amount A component used is more than 0% stoichiometric ratio excess based on the base number. In one example, the stoichiometric ratio excess of A, is no more than 50%, such as from greater than 0 to 30% by mole.

The base number of B is y-x, and the amount of B component used can, for instance, vary around 100% stoichiometric ratio. In one example, the percentage of B can be in the range of 80-120% stoichiometric ratio; such as 90-110% stoichiometric ratio, for instance 99-101% stoichiometric ratio.

In view of the above, one embodiment of the present invention includes a composition having the stated stoichiometric ratio excess. Such a composition may be used, for instance, for preparing the clathrate compound of formula (I). The composition can contain the following components, for instance: 9.2-16 parts by mole of M, x parts by mole of A and (y-x) parts by mole of B, wherein the meanings of the components of M, A, B, x and y are as defined in formula (I).

An acid-washing technique may also be used in the preparation of a high purity and high performance clathrate thermoelectric material having a Type I clathrate structure.

In view of the above, one embodiment of the present invention includes a process for making the clathrate compound of the present invention, which comprises the following steps:
(a) providing a mixture of the components M, A and B, at least one of which is provided in stoichiometric excess, wherein
   M is an alkaline earth metal, a rare earth metal, an alkali metal, Cd, or a combination thereof,
   A is Ga, Al, In, Zn or a combination thereof;
   B is Ge, Si, Sn, Ni or a combination thereof;
(b) melting and quenching the mixture from step (a) to obtain a quenched mixture;
(c) crushing the quenched mixture from step (b) to a powder;
(d) washing the powder from step (c) with an acid to obtain a washed powder of the quenched mixture; and
(e) sintering the washed powder of the quenched mixture from step (d) to obtain the clathrate compound.

As an example, the process for making the clathrate compound of the invention may comprise the following steps:
(a) providing a mixture of the components M, A and B, and the mixture comprising 9.2 to 16 parts by mole of M, (x-1.5x) parts by mole of A, and (0.8-1.2)*(y-x) parts by mole ofB,
   wherein
   M is an alkaline earth metal, a rare earth metal, an alkali metal, Cd or a combination thereof,
   A is Ga, Al, In, Zn or a combination thereof;
   B is Ge, Si, Sn, Ni or a combination thereof;
   12≤x≤16, 40≤y≤43;
(b) heating the mixture from step (a) to a sufficiently molten state, which is then quenched to obtain a quenched mixture;
(c) crushing the quenched mixture from step (b) to a powder,
(d) removing the impurities and excessive starting materials with an acid wash to obtain a powder of the quenched mixture; and
(e) sintering the powder of the quenched mixture from step (d) by Spark Plasma Sintering (SPS) to obtain the clathrate compound.

In step (a), it can be beneficial to provide a mixture comprising 9.2-16 parts by mole of M (i.e. 15-100% excess, such as 15-40% excess, for instance 15%-25% excess), (x-1.5x) parts by mole of A, and (y-1.5y) parts by mole of B; wherein 12≤x≤16, 40≤y≤43.

The components M, A and B are all commercially available. The components M, A and B can exist in various of physical states, such as powders, granules, or molten liquids. If the components M, A, and B are single components, they can be in the form of simple substances. If the components M, A and B are mixed components, they can be in the form of a mixture of simple substances or in the form of an alloy.

The mixing of the above components can be performed by a conventional mixing manner in the art, such as direct mixing. Alternatively, each component can be firstly treated (for example, crushed to a powder or granulated) respectively and then mixed together. These mixing methods are well-known to the skilled in the art, provided that they will not affect the subsequent melting step.

In step (b), the mixture from step (a) is heated to a sufficiently molten state, and then is quenched to obtain a quenched mixture. "A sufficiently molten state" mentioned here refers to a state in which a substance is heated above its melting point for a sufficient period to ensure that the substance is sufficiently molten. The process to heat the components of the present invention to "a sufficiently molten state" is well known, and one skilled in the art can determine the temperature of sufficient melting, such as with the use of technical handbooks (for example, according to a phase diagram). Generally, the temperature for heating the mixture to a sufficiently molten state can include but is not limited to a temperature between 900 °C and 1200 °C.

The method for quenching used in the present invention is well known in the art, and the skilled person in this technical field can determine the quenching temperature according to technical handbooks. Generally, the quenching may be carried out, for instance, in oil, brine, ice water or iced brine.

In step(c), the quenched mixture from step (b) is crushed into a powder. Furthermore, in order to make the material of the present invention have high purity and the vacancy of the crystal lattice atoms, acid washing process is used in step (d) to remove the impurities and excess starting materials.

In an exemplary embodiment, hydrochloric acid is used in the acid-washing process. The acid may be used in any acceptable concentration, such as a concentration of 30%-50%. The ratio of the acid to the clathrate compound may be any appropriate ratio, such as 50:1 to 400:1, for instance 100:1 to 200:1.

In step (e), the powders of the quenched mixture from step (d) can be sintered by Spark Plasma Sintering (SPS) to obtain the clathrate compound.

Spark Plasma Sintering procedures are conventional steps to obtain the clathrate compound of the present invention and can be performed according to the conventional schemes in the art. Exemplary conditions for the Spark Plasma Sintering are as follows: degree of vacuum: 6 Pa or filled with protective inert gas (such as argon, nitrogen or a mixture of argon and nitrogen); pressure: 40-80 MPa (such as 50-70 MPa); rate of rise: 50-150 °/min (such as 70-120 °/min); holding time for the maximal temperature: 1-10 minutes (such as 3-7 minutes). In one example, the holding temperature in the sintering process of the present invention is controlled between 500 °C and 850 °C.

The clathrate compound of the present invention obtained by the above process has a type I clathrate structure. The definition of "Type I clathrate structure" is known to the skilled in the art and can be found in literature such as "Thermoelectrics: Basic Principles and New Materials Developments", G. S. Nolas, Springer, 2001.

The clathrate compound of the present invention can also be prepared by other methods to obtain other types of clathrate structures, such as Type VIII clathrate structures. Such other methods include those generally described in "Thermoelectrics: Basic Principles and New Materials Developments", G. S. Nolas, Springer, 2001.

In yet a further embodiment embodiment, the following procedures can be used to prepare a clathrate compound of formula (I):

### 1. Melting of starting materials

The starting metal material M is selected from an alkaline earth metal or a rare earth metal or an alkali metal or Cd atom, or a combination thereof. The alkaline earth metal is one of Sr and Ba or the combination thereof. The rare earth metal is one of Eu and Yb or the combination thereof. The alkali metal is one of K and Na or the combination thereof. The starting metal material A is Ga or Al or In or Zn or the combination of Ga, Al, In, and Zn. The starting metal material B is Ge or Si or Sn or Ni or the combination of Ge, Si, Sn, and Ni.

The starting materials are mixed according to the chemical formula M₈AₓB_{y-x}, and sealed in a quartz ampoule. Then the above materials are heated to a sufficiently molten state and then quenched, wherein 12≤x≤16, 40≤y≤43. The starting metal material M is at least 15 mol% in excess.

### 2. Acid-washing

The product obtained in step 1 is crushed into powders which are washed by an acid such as hydrochloric acid to remove the impurities and excess starting materials.

### 3. Sintering

The powders from step 2 are dried and sintered by Spark Plasma Sintering into a dense bulk and the holding temperature is controlled between 500 °C to 850 °C.

The thermoelectric material obtained by the above process has Type I clathrate structure and has the general formula of M₈AₓB_{y-x}, wherein 12≤x≤16, 40≤y≤43, M is an alkaline earth metal or a rare earth metal or an alkali metal or Cd or a combination thereof; A is Ga or Al or In or Zn or the combination of Ga, Al, In, and Zn; wherein B is Ge or Si or Sn or Ni or the combination of Ge, Si, Sn and Ni.

The alkaline earth metal is, for instance, one of Sr and Ba or a combination thereof. The rare earth metal is, for instance, one of Eu and Yb or a combination thereof. The alkali metal is, for instance, one of K and Na or a combination thereof. M is, for instance, Ba or Sr or Eu. A is, for instance, Ga. B is, for instance, Ge.

In view of the above, the present invention can obtain compounds of formula (I) above having different ratios of A/B to optimize the thermoelectric performance of the material by using different ratios of starting materials A to B.

Furthermore, the synthetic methods mentioned above are exemplary only. All or a portion of the compounds of the invention may also be made using any other appropriate techniques.

### Thermoelectric materials

The clathrate compound of formula (I) can, for example, be combined with other components in a conventional manner to obtain a composite thermoelectric material. For example, it can be mixed with skutterudite (including CoSb₃, OsSb₃) and filled skutterudite thermoelectric material, PbTe, as non-limiting examples.

The present invention also provides a thermoelectric material comprising the clathrate compound of the present invention. In an exemplary embodiment, the ZT of the thermoelectric material is no less than 1.1 at 900K. More generally, due to their desirable properties, the clathrate compound of the present invention can be used in thermoelectric materials, magnetic materials, superconductive materials, or a combination thereof.

### EXAMPLES

The invention will be further illustrated by the following examples. It is appreciated that these examples are only intended to illustrate the invention, but not to limit the scope of the invention. For the experimental methods in the following examples, they are performed under routine conditions, or as instructed by the manufacturers, unless otherwise specified. All the parts or percentages are based on mole, unless otherwise specified.

The technical terms used in the present application have the same meanings as those known to the skilled in the art, unless otherwise specified. In addition, all the methods and materials similar or equivalent to those described in the present application can also be applied to the method of the present invention.

### Example 1: preparation of the clathrate compound Ba₈Ga₁₂Ge₂₉

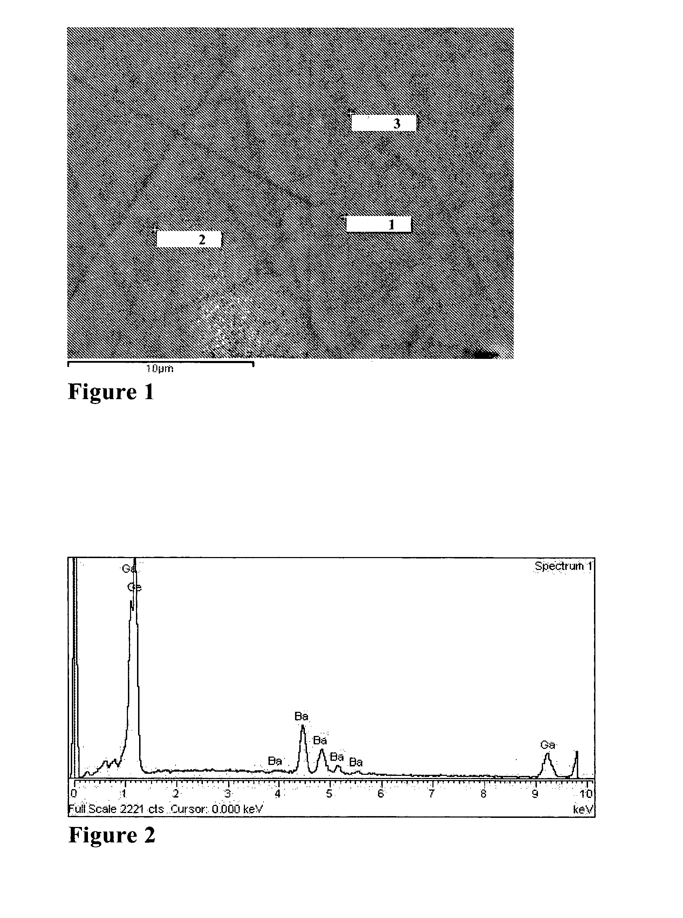

The starting materials, Ba, Ga and Ge, were weighed in the molar ratio of 9.3 (16.2% excess): 14.5 (20.8 % excess): 29 and sealed in a quartz ampoule. The sealed starting materials were heated to 1080 °C. After the materials were melted at 1080 °C for 10 hours, the quartz ampoule was quenched in water and a crystal bar was obtained. The bar was crushed to powders and soaked in a hydrochloric acid solution (the concentration of the hydrochloric acid is 30%, and the ratio of the acid to the powder by weight is 100:1) to wash the powders with the acid. The washed powder was dried and then sintered by Spark Plasma Sintering (ramp rate: 100 °/min) in vacuum (vacuum degree of 6 Pa) at 730 °C for three minutes into a dense bulk. It can be seen from the SEM image of the polished surface (Figure 1) and the energy spectrum analysis figure (Figure 2) that the obtained material has a pure phase. The results of the element atomic percent in the energy spectrum analysis for the three areas in Figure 1 (labeled 1, 2 and 3) are listed in Table 3:

**TABLE 3: COMPOSITION ANALYSIS OF THE CLATHRATE COMPOUND OF EXAMPLE 1**

| Spectrum area | Element Atomic% | | |
|---|---|---|---|
| | Ba | Ga | Ge |
| 1 | 16.42 | 24.53 | 59.05 |
| 2 | 16.47 | 24.27 | 59.26 |
| 3 | 16.38 | 24.60 | 59.02 |
| Average value | 16.42 | 24.47 | 59.11 |

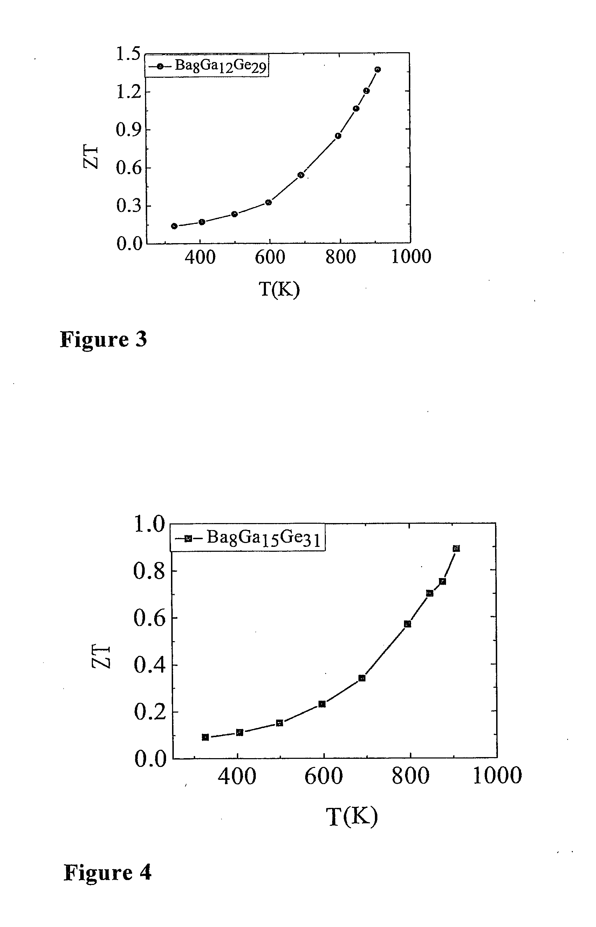

Each part of the material had a uniform composition Ba₈Ga₁₂Ge₂₉, and some crystal lattice atoms are vacant. Based on the values of thermal conductivity, electric conductivity and Seebeck coefficient, the ZT value was calculated, and the results showed that the clathrate material having the structure of Ba₈A₁₂B₂₉ (Ba₈Ga₁₂Ge₂₉) has excellent thermoelectric properties. As shown in Figure 3, the maximal ZT for Ba₈Ga₁₂Ge₂₉ is 1.35. Additional results can be seen in the performance examples below.

### Example 2: preparation of the clathrate compound Sr₈Ga₁₃Ge₂₇

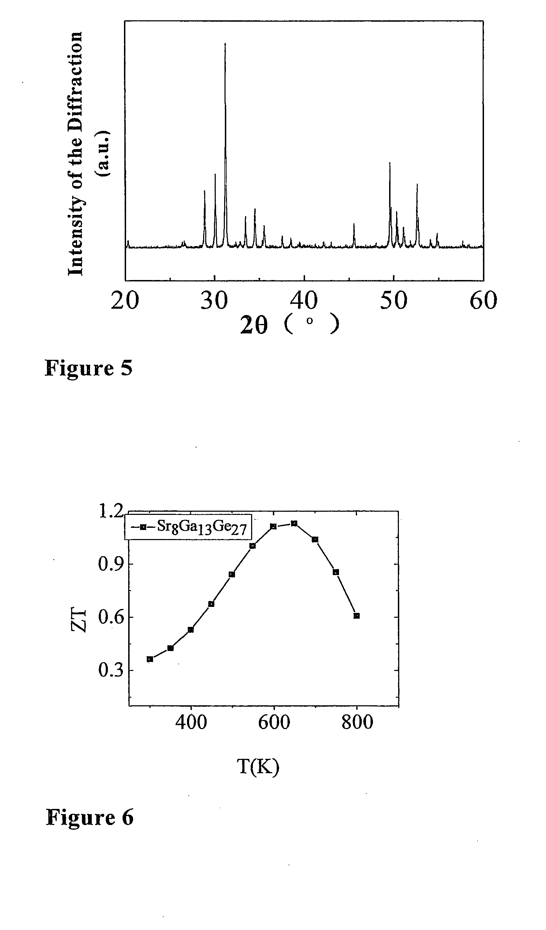

The starting materials, Sr, Ga and Ge, were weighed in the molar ratio of 9.25 (15.6% excess): 15.4 (18.5 % excess): 27 and sealed in a quartz ampoule. The sealed starting materials were heated to 1080 °C. After the materials were melted at 1080 °C for 4 hours, the quartz ampoule was quenched in oil and a crystal bar was obtained. The bar was crushed to a powder and soaked in a hydrochloric acid solution (the concentration of the hydrochloric acid is 50%, and the ratio of the acid to the powder by weight is 50:1) to wash the powders with the acid. The washed powder was dried and then sintered by Spark Plasma Sintering in vacuum at 650 °C into a dense bulk. It can be seen from the X-ray diffraction pattern as shown in Figure 5 that the obtained material has a clathrate phase of Type I clathrate structure. The energy spectrum analysis indicated that each part of the material has a uniform composition Sr₈Ga₁₃Ge₂₇. Based on the values of thermal conductivity, electric conductivity and Seebeck coefficient, the ZT value was calculated, and the result shows that the clathrate material having the structure of Sr₈A₁₃B₂₇ (Sr₈Ga₁₃Ge₂₇) has excellent thermoelectric properties. As shown in Figure 6, the maximal ZT for Sr₈Ga₁₃Ge₂₇ is 1.1.

### Example 3: preparation of the clathrate compound Eu₈Ga₁₆Ge₂₆

The starting materials, Eu, Ga and Ge, were weighed in the molar ratio of 9.2 (15% excess): 18.3 (14.4 % excess): 26 and sealed in a quartz ampoule. The sealed starting materials were heated to 1080 °C. After the materials were melted at 1080 °C for 4 hours, the quartz ampoule was quenched in ice water and a crystal bar was obtained. The bar was crushed to a powder and soaked in a hydrochloric acid solution (the concentration of the hydrochloric acid is 30%, and the ratio of the acid to the powder by weight is 100:1) to wash the powders with the acid. The washed powder was dried and then sintered by Spark Plasma Sintering in vacuum at 550 °C into a dense bulk. The energy spectrum analysis indicated that each part of the material has a uniform composition Eu₈Ga₁₆Ge₂₆.

### Examples 4 to 15

The clathrate compounds having the following formulas were synthesized in a similar manner as Example 1, with exceptions indicated in the following Tables 4-6.

**TABLE 4: CLATHRATE COMPOUNDS OF EXAMPLES 4 TO 15 (MOLAR RATIOS INDICATED)**

| **Example** | **Formula** | **Additional details** |
|---|---|---|
| Example 4 | (Sr,Ba)₈Al₁₂Si_{28.5} | M is a combination of Sr and Ba, and the ratio of Sr and Ba is 1: 1.2 |
| Example 5 | (Sr,Eu)₈In₁₃Sn₂₇ | M is a combination of Sr and Eu, and the ratio of Sr and Eu is 1:2.9 |
| Example 6 | (Ba,Eu)₈Ga₁₄Ge₂₇ | M is a combination of Ba and Eu, and the ratio of Ba and Eu is 3:1 |
| Example 7 | (Sr,Yb)₈Ga₁₅Ge₂₆ | M is a mixture of Sr and Yb, and the ratio of Sr to Yb in the mixture is 7:1 |
| Example 8. | (Eu,Yb)₈Ga₁₆Ge₂₆ | M is a mixture of Eu, Yb, and the ratio of Eu to Yb in the mixture is 7:1 |
| Example 9 | Ba₈(Ga,Al)₁₂Ge₃₀ | The ratio of Ga to Al is about 10:1 |
| Example 10 | Sr₈(Ga,In)₁₃Si₂₉ | The ratio of Ga to In is 1:10 |
| Example 11 | Eu₈(Ga,Zn)₁₄Sn₂₇ | The ratio of Ga to Al is 15:1 |
| Example 12 | Yb₈A₁₅(Ge,Si)₂₇ | The ratio of Ge to Si is 10:1 |
| Example 13 | (Ba, Sr)₈A₁₆(Ge,Sn)₂₆ | The ratio of Ge to Sn is 1:10; |
| Example 14 | (Ba, Eu)₈A₁₂(Si,Sn)₂₈ | The ratio of Si to Sn is 1:10 |
| Example 15 | (Ba, Eu)₈A₁₄(Si,Sn)₂₉ | The ratio of Si to Sn is 1: 10 |

The same preparation conditions as those mentioned in Example 1 are used, with the exceptions shown in Table 5.

**TABLE 5: CONDITIONS FOR THE PREPARATION OF CLATHRATE COMPOUNDS OF EXAMPLES 4 TO 15**

| **Example** | **Proportion of starting materials** | **Conditions of acid washing** |
|---|---|---|
| Example 4 | 4.8: 6: 14: 28.5 | the concentration of the hydrochloric acid is 50%, the ratio of the acid to the sample by weight is 100:1 |
| Example 5 | 2.6: 7.5: 15: 27 | the concentration of the hydrochloric acid is 50%, the ratio of the acid to the sample by weight is 50:1 |
| Example 6 | 8: 2.6: 16: 27 | the concentration of the hydrochloric acid is 50%, the ratio of the acid to the sample by weight is 130:1 |
| Example 7 | 8.4: 1.2: 17.5: 26 | the concentration of the hydrochloric acid is 50%, the ratio of the acid to the sample by weight is 180:1 |
| Example 8 | 8.4: 1.2: 18: 26 | the concentration of the hydrochloric acid is 50%, the ratio of the acid to the sample by weight is 70:1 |
| Example 9 | 14: 13.5: 1.4: 30 | the concentration of the hydrochloric acid is 50%, the ratio of the acid to the sample by weight is 200:1 |
| Example 10 | 9.6: 1.4: 14: 29 | the concentration of the hydrochloric acid is 50%, the ratio of the acid to the sample by weight is 130:1 |
| Example 11 | 10: 15: 1: 27 | the concentration of the hydrochloric acid is 50%, the ratio of the acid to the sample by weight is 170:1 |
| Example 12 | 9.5: 16.5: 24.5: 2.5 | the concentration of the hydrochloric acid is 50%, the ratio of the acid to the sample by weight is 90:1 |
| Example 13 | 8: 2: 14.5: 2.6: 25.5 | the concentration of the hydrochloric acid is 50%, the ratio of the acid to the sample by weight is 100:1 |
| Example 14 | 8: 2: 14.5: 2.6: 25.5 | the concentration of the hydrochloric acid is 50%, the ratio of the acid to the sample by weight is 50:1 |
| Example 15 | 9: 1: 14.5: 2.6: 25.5 | the concentration of the hydrochloric acid is 50%, the ratio of the acid to the sample by weight is 50:1 |

The stoichiometric ratio excess in Examples 4-15 is as shown in the following Table 6.

**TABLE 6: STOICHIOMETRIC RATIO EXCESS IN THE PREPARATION OF CLATHRATE COMPOUNDS OF EXAMPLES 4 TO 15**

| **Example** | **Formula** | **Proportion of starting materials** | **Stoichiometric ratio excess of M-A-B (% by mole)** |
|---|---|---|---|
| Example 4 | (Sr,Ba)₈Al₁₂Si_{28.5} | 4.8: 6: 14: 28.5 | 35%-16%-0 |
| Example 5 | (Sr,Eu)₈In₁₃Sn₂₇ | 2.6: 7.5: 15: 27 | 26.2%-15.4%-0 |
| Example 6 | (Ba,Eu)₈Ga₁₄Ge₂₇ | 8: 2.6: 16: 27 | 35%-14.3%-0 |
| Example 7 | (Sr,Yb)₈Ga₁₅Ge₂₆ | 8.4: 1.2: 17.5: 26 | 20%-16.7%-0 |
| Example 8 | (Eu,Yb)₈Ga₁₆Ge₂₆ | 8.4: 1.2: 18: 26 | 20%-12.5%-0 |
| Example 9 | Ba₈(Ga,Al)₁₂Ge₃₀ | 14: 13.5: 1.4: 30 | 75%-24%-0 |
| Example 10 | Sr₈(Ga,In)₁₃Si₂₉ | 9.6: 1.4: 14: 29 | 20%-18.4%-0 |
| Example 11 | Eu₈(Ga,Zn)₁₄Sn₂₇ | 10: 15: 1: 27 | 25%-14.3%-0 |
| Example 12 | Yb₈A₁₅(Ge,Si)₂₇ | 9.5:16.5:24.5: 2.5 | 18.8%-10%-0 |
| Example 13 | (Ba, Sr)₈A₁₆(Ge,Sn)₂₆ | 10: 17.5: 2.4: 23.5 | 25%-9%-0 |
| Example 14 | (Ba, Eu)₈A₁₂(Si,Sn)₂₈ | 8: 2: 14.5: 2.6: 25.5 | 25%-21%-0.4% |
| Example 15 | (Ba, Eu)₈A₁₄(Si,Sn)₂₉ | 9: 1: 14.5: 2.5: 26.5 | 25%-4%-0 |

### Comparative Example A: preparation of the clathrate compound Ba₈Ga₁₅Ge₃₁

The starting materials, Ba, Ga and Ge, were weighed in the proportion of 8:16:31 and sealed in a quartz ampoule. The sealed starting materials were heated to 1080 °C. After the materials were melted at 1080 °C for 10 hours, the quartz ampoule was quenched in water and a crystal bar was obtained. The bar was crushed to a powder and soaked in a dilute hydrochloric acid solution to wash the powders with the acid. The washed powder was dried and then sintered by a Spark Plasma Sintering into a dense bulk in vacuum at 730 °C. SEM of the polished surface and energy spectrum analysis figure showed that the obtained material is Ba₈Ga₁₅Ge₃₁ with some germanium phase. The atoms in the crystal lattice are not vacant. Based on the values of thermal conductivity, electric conductivity and Seebeck coefficient, the ZT value of Ba₈Ga₁₅Ge₃₁ is calculated, and the result shows that the thermoelectric property of Ba₈Ga₁₅Ge₃₁ is poorer than those of Ba₈Ga₁₂Ge₂₉, and the maximal ZT is only 0.9, as shown in Figure 4.

### Performance Examples

### Test Methods and Standards

Tests of the materials of the Examples were conducted according to the method described in "Thermoelectrics: Basic Principles and New Materials Developments", G. S. Nolas, Springer, 2001.

### Performance measurement

The ZT value was calculated by measurement of thermal conductivity, conductivity and Seebeck coefficient, and the result showed that clathrate material having the structure of Ba₈A₁₂B₂₉ has excellent thermoelectric properties.

Similarly, the ZTs for Examples 2-15 were tested and the performances of the materials in Examples 1-15 are shown in the following Table 7:

**TABLE 7: PERFORMANCE MEASUREMENTS FOR THE CLATHRATE COMPOUNDS OF EXAMPLES 1 TO 15**

| **Example** | **Maximal ZT** |
|---|---|
| Example 1 | 1.35 |
| Example 2 | 1.10 |
| Example 3 | 1.15 |
| Example 4 | 1.16 |
| Example 5 | 1.24 |
| Example 6 | 1.28 |
| Example 7 | 1.30 |
| Example 8 | 1.32 |
| Example 9 | 1.25 |
| Example 10 | 1.10 |
| Example 11 | 1.14 |
| Example 12 | 1.15 |
| Example 13 | 1.12 |
| Example 14 | 1.15 |
| Example 15 | 1.05 |
| Comparative Example A | 0.9 |

### Identification of the structures

In order to identify the structure of the compound obtained by the method of the present invention, the sample of Example 1 was tested.

A scanning electron microscope (SEM) image of the polished surface is shown in Figure 1. A figure of energy spectrum analysis is shown in Figure 2. The results of the element atomic percent in the energy spectrum analysis for the three areas in Figure 1 have been listed in Table 3, which indicate that each part of the material has a uniform composition Ba₈Ga₁₂Ge₂₉, and some atoms in the crystal lattice are vacant.

The results mentioned above reveal that the obtained materials have pure phases.

In order to identify the structure of the compound obtained by the method of the present invention, the sample of Example 2 was tested. X-ray diffraction pattern of Sr₈Ga₁₃Ge₂₇ in Example 2 was taken, which indicates that the obtained material has a type I clathrate structure phase.

It should also be understood that the precise numerical values used in the specification and claims form additional embodiments of the invention. Efforts have been made to ensure the accuracy of the numerical values disclosed herein. Any measured numerical value, however, can inherently contain certain errors resulting from the standard deviation found in its respective measuring technique.

As used herein the use of "the," "a," or "an" means "at least one," and should not be limited to "only one" unless explicitly indicated to the contrary.

## Claims

1. A clathrate compound of formula (I)
M₈AₓB_{y-x} (I)
wherein:
M is an alkaline earth metal, a rare earth metal, an alkali metal, Cd, or a combination thereof;
A is Ga, Al, In, Zn or a combination thereof;
B is Ge, Si, Sn, Ni or a combination thereof; and
12≤x≤16, 40≤y≤43.

2. The clathrate compound according to claim 1, wherein the clathrate compound has a type I clathrate structure.

3. The clathrate compound according to any one of claims 1-2, wherein M is an alkaline earth metal.

4. The clathrate compound according to any one of claims 1-2, wherein M is a rare earth metal.

5. The clathrate compound according to any one of claims 1-2, wherein M is an alkali metal.

6. The clathrate compound according to any one of claims 1-2, wherein M is Cd.

7. The clathrate compound according to any one of claims 1-6, wherein A is Ga.

8. The clathrate compound according to any one of claims 1-6, wherein A is Al, In or Zn.

9. The clathrate compound according to any one of claims 1-8, wherein B is Ge.

10. The clathrate compound according to any one of claims 1-8, wherein B is Si, Sn or Ni.

11. A process for preparing the clathrate compound of any one of claims 1-10, which comprises:
(a) providing a mixture of the components A, B and M, at least one of which is provided in stoichiometric excess,
(b) melting and quenching the mixture from step (a) to obtain a quenched mixture;
(c) crushing the quenched mixture from step (b) to a powder,
(d) washing the powder from step (c) with an acid to obtain a washed powder of the quenched mixture; and
(e) sintering the washed powder of the quenched mixture from step (d) to obtain the clathrate compound.

12. The process according to claim 11, wherein in step (a) M is at least 15 mole % stoichiometric ratio excess.

13. A thermoelectric material comprising the clathrate compound according to any one of claims 1-12.

14. A magnetic or superconductive material comprising the clathrate compound according to any one of claims 1-12.

## Patentansprüche

1. Clathratverbindung der Formel (I)
M₈AₓB_{y-x} (I)
worin:
M für ein Erdalkalimetall, ein Seltenerdmetall, ein Alkalimetall, Cd oder eine Kombination davon steht;
A für Ga, Al, In, Zn oder eine Kombination davon steht;
B für Ge, Si, Sn, Ni oder eine Kombination davon steht; und
12≤x≤16,40≤y≤43.

2. Clathratverbindung nach Anspruch 1, wobei die Clathratverbindung eine Clathratstruktur des Typs I aufweist.

3. Clathratverbindung nach einem der Ansprüche 1 - 2 wobei M für ein Erdalkalimetall steht.

4. Clathratverbindung nach einem der Ansprüche 1 - 2 wobei M für ein Seltenerdmetall steht.

5. Clathratverbindung nach einem der Ansprüche 1 - 2 wobei M für ein Alkalimetall steht.

6. Clathratverbindung nach einem der Ansprüche 1 - 2 wobei M für Cd steht.

7. Clathratverbindung nach einem der Ansprüche 1 - 6 wobei A für Ga steht.

8. Clathratverbindung nach einem der Ansprüche 1 - 6 wobei A für Al, In oder Zn steht.

9. Clathratverbindung nach einem der Ansprüche 1 - 8 wobei B für Ge steht.

10. Clathratverbindung nach einem der Ansprüche 1 - 8 wobei B für Si, Sn oder Ni steht.

11. Verfahren zum Herstellen der Clathratverbindung nach einem der Ansprüche 1 - 10, umfassend:
(a) Bereitstellen einer Mischung der Komponenten A, B und M, von denen zumindest eine in stöchiometrischem Überschuss bereitgestellt wird,
(b) Schmelzen und Quenchen der Mischung aus Schritt (a), um eine gequenchte Mischung zu erhalten;
(c) Zerstoßen der gequenchten Mischung aus Schritt (b) zu einem Pulver,
(d) Waschen des Pulvers aus Schritt (c) mit einer Säure, um ein gewaschenes Pulver aus der gequenchten Mischung zu erhalten; und
(e) Sintern des gewaschenen Pulvers aus der gequenchten Mischung von Schritt (d), um die Clathratverbindung zu erhalten.

12. Verfahren nach Anspruch 11, wobei in Schritt (a) M in einem mindestens 15 mol%-igen stöchiometrischen Überschuss vorliegt.

13. Thermoelektrisches Material, die Clathratverbindung nach einem der Ansprüche 1 - 12 aufweisend.

14. Magnetisches oder superleitendes Material, die Clathratverbindung nach einem der Ansprüche 1 - 12 aufweisend.

## Revendications

1. Un composé de clathrate de formule (I)
M₈AₓB_{y-x} (I)
où :
M est un métal alcalino-terreux, un métal de terres rares, un métal alcalin, Cd, ou une combinaison de ceux-ci,
A est Ga, Al, In, Zn ou une combinaison de ceux-ci,
B est Ge, Si, Sn, Ni ou une combinaison de ceux-ci, et
12≤x≤16, 40≤y≤43.

2. Le composé de clathrate selon la Revendication 1, où le composé de clathrate possède une structure clathrate de type I.

3. Le composé de clathrate selon l'une quelconque des Revendications 1 à 2, où M est un métal alcalino-terreux.

4. Le composé de clathrate selon l'une quelconque des Revendications 1 à 2, où M est un métal de terres rares.

5. Le composé de clathrate selon l'une quelconque des Revendications 1 à 2, où M est un métal alcalin.

6. Le composé de clathrate selon l'une quelconque des Revendications 1 à 2, où M est Cd.

7. Le composé de clathrate selon l'une quelconque des Revendications 1 à 6, où A est Ga.

8. Le composé de clathrate selon l'une quelconque des Revendications 1 à 6, où A est Al, In ou Zn.

9. Le composé de clathrate selon l'une quelconque des Revendications 1 à 8, où B est Ge.

10. Le composé de clathrate selon l'une quelconque des Revendications 1 à 8, où B est Si, Sn ou Ni.

11. Un procédé de préparation du composé de clathrate selon l'une quelconque des Revendications 1 à 10, qui comprend :
(a) la fourniture d'un mélange des composants A, B et M, au moins un d'entre eux étant fourni en excès stoechiométrique,
(b) la fusion et la trempe du mélange de l'opération (a) de façon à obtenir un mélange trempé,
(c) le broyage du mélange trempé de l'opération (b) en une poudre,
(d) le lavage de la poudre de l'opération (c) avec un acide de façon à obtenir une poudre lavée du mélange trempé, et
(e) le frittage de la poudre lavée du mélange trempé de l'opération (d) de façon à obtenir le composé de clathrate.

12. Le procédé selon la Revendication 11, où, à l'opération (a), M est au moins 15% en moles en excès de rapport stoechiométrique.

13. Un matériau thermoélectrique contenant le composé de clathrate selon l'une quelconque des Revendications 1 à 12.

14. Un matériau magnétique ou supraconducteur contenant le composé de clathrate selon l'une quelconque des Revendications 1 à 12.
